# EUROPEAN PATENT SPECIFICATION

(11) **EP 1 519 642 B1**
(45) Date of publication and mention of the grant of the patent: **09.11.2011**
(21) Application number: 04022698.7
(22) Date of filing: 23.09.2004
(51) Int. Cl.: H05K 3/32, H01G 2/06

(54) **Electronic component mounting method and electronic component mounting structure**
Verfahren und Struktur zur Montierung eines elektronischen Bauteils
Procédé et structure de montage d'un composant électronique

(30) Priority: 29.09.2003 JP 2003337386
(43) Date of publication of application: 30.03.2005
(73) Proprietor: TDK Corporation, Tokyo 103-8272 (JP)
(72) Inventor: Yoishii, Akitoshi, Tokyo 103-8272 (JP); Yokoyama, Hideki, Tokyo 103-8272 (JP); Takeda, Atsushi, Tokyo 103-8272 (JP); Kimura, Miki, Tokyo 103-8272 (JP); Kazama, Sachi, Tokyo 103-8272 (JP); Okabe, Masayuki, Tokyo 103-8272 (JP)
(74) Representative: Strych, Werner Maximilian Josef

(56) References cited:
- US-A- 5 400 953
- US-A- 6 012 231
- US-A1- 2002 166 685
- PATENT ABSTRACTS OF JAPAN vol. 2000, no. 21, 3 August 2001 (2001-08-03) -& JP 2001 102715 A (FUJITSU GENERAL LTD), 13 April 2001 (2001-04-13)
- MOSHAMMER A: "CERAMIC CHIP CAPACITORS FOR CONDUCTIVE BONDING" COMPONENTS, SIEMENS AKTIENGESELLSCHAFT. MUNCHEN, DE, vol. 26, no. 3, 1 July 1991 (1991-07-01), pages 117-119, XP000259375 ISSN: 0945-1137
- PATENT ABSTRACTS OF JAPAN vol. 1999, no. 05, 31 May 1999 (1999-05-31) & JP 11 054894 A (FUJITSU TEN LTD), 26 February 1999 (1999-02-26)
- PATENT ABSTRACTS OF JAPAN vol. 018, no. 577 (E-1625), 4 November 1994 (1994-11-04) & JP 06 216509 A (SONY CORP), 5 August 1994 (1994-08-05)

## Description

### BACKGROUND OF THE INVENTION

### 1. FIELD OF THE INVENTION

The present invention relates to an electronic component mounting method and an electronic component mounting structure that prevent the occurrence of short or ion migration even when a conductive adhesive is crushed between an electronic component and a circuit board, and more particularly, to those suitable for use in mounting a multilayer ceramic capacitor on the circuit board.

### 2. DESCRIPTION OF THE RELATED ART

In recent years, sets of electric appliances and so on are remarkably downsized, and downsizing of chip-type electronic components such as multilayer ceramic capacitors mounted on circuit boards to be built in such electric appliances is also rapidly underway. Meanwhile, in recent years, more electric appliances use conductive adhesives for mounting electronic components on circuit boards, which naturally gives rise to a demand for the downsizing of electronic components that are mounted via conductive adhesives.

This conductive adhesive, unlike solder, do not have a self-aligning function of correcting the position of an electronic component when it cures after the electronic component is mounted on a circuit board. Therefore, if the electronic component is placed at a misaligned position on the circuit board for mounting, the conductive adhesive cures while this misaligned state is kept. Consequently, even when the conductive adhesive is crushed and spread by a pressure for mounting the electronic component on the circuit board, the conductive adhesive cures as it is.

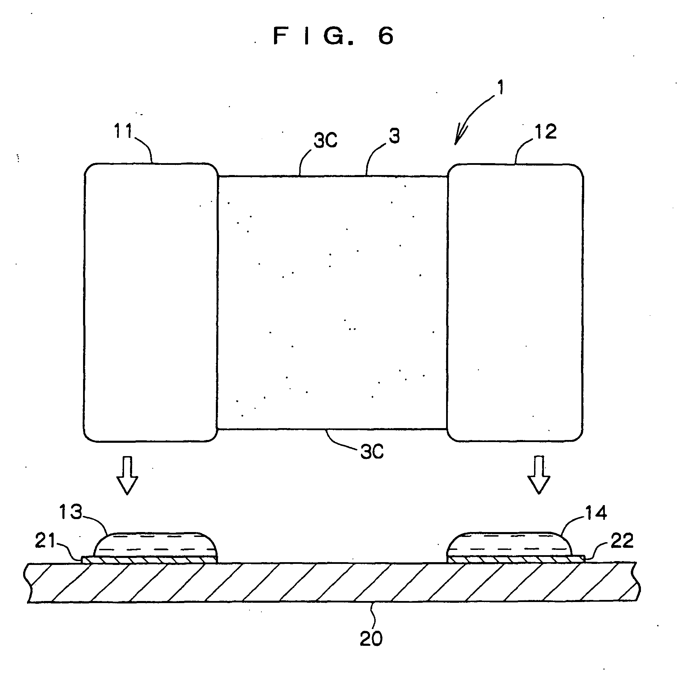

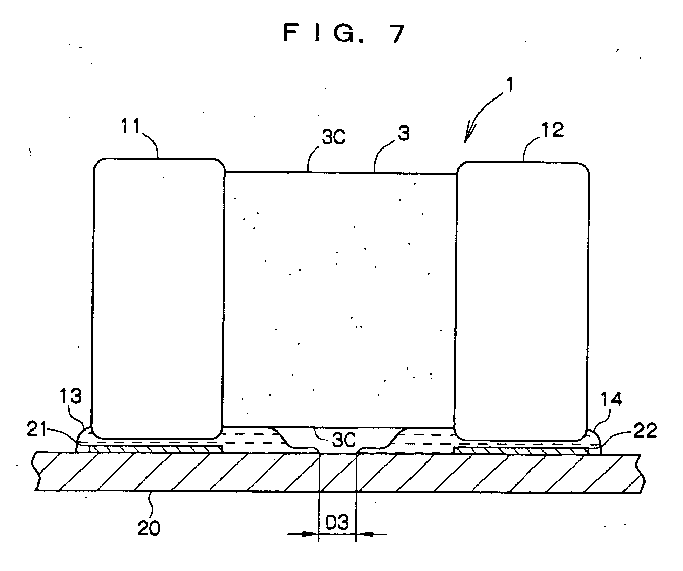

Accordingly, when conductive adhesives 13, 14 shown in FIG. 6 are used in mounting a multilayer ceramic capacitor 1, which is a small electronic component, on a circuit board 20, the conductive adhesives 13, 14 are crushed to spread between terminal electrodes 11, 12 of the multilayer ceramic capacitor 1 and the circuit board 20 as shown in FIG. 7. This narrows a gap dimension D3, which may possibly result in the occurrence of short or ion migration.

The following reasons are possible reasons why a conductive adhesive spreads to cause problems such as the aforementioned short when an electronic component is mounted on a circuit board. Firstly, an amount of the conductive adhesive is too large, secondly, the pressure for mounting the electronic component is too high, thirdly, an interval between the pair of terminal electrodes is too narrow, fourthly, an interval between a portion of an electronic component sandwiched by the pair of terminal electrodes and the circuit board is too narrow, and so on.

However, since the downsizing of an electronic component naturally results in a narrowed interval between the pair of terminal electrodes, it has been difficult to adopt a measure of widening the interval between the pair of terminal electrodes in order to solve the problem caused by the reason, among the above-cited reasons, that the interval between the pair of terminal electrodes of the electronic component is too narrow.

### SUMMARY OF THE INVENTION

In view of the above-described situation, it is an object of the present invention to provide an electronic component mounting method and an electronic component mounting structure that prevent the occurrence of short or ion migration even when a conductive adhesive is crushed between an electronic component and a circuit board.

The present invention is defined by the features in the appended claims.

### BRIEF DESCRIPTION OF THE DRAWINGS

FIG. 1 is a front view showing the state before a multilayer capacitor applied to a first embodiment of the present invention is mounted on a circuit board;
FIG. 2 is a front view showing the state when the multilayer capacitor applied to the first embodiment of the present invention is mounted on the circuit board;
FIG. 3 is an exploded perspective view of the multilayer capacitor applied to the first embodiment of the present invention;
FIG. 4 is a cross-sectional view showing the multilayer capacitor applied to the first embodiment of the present invention;
FIG. 5 is a front view showing the state when a multilayer capacitor applied to a second embodiment of the present invention is mounted on a circuit board;
FIG. 6 is a front view showing the state of a conventional example before a multilayer capacitor is mounted on a circuit board; and
FIG. 7 is a front view showing the state of the conventional example when the multilayer capacitor is mounted on the circuit board.

### DETAILED DESCRIPTION OF THE PREFERRED EMBODIMENTS

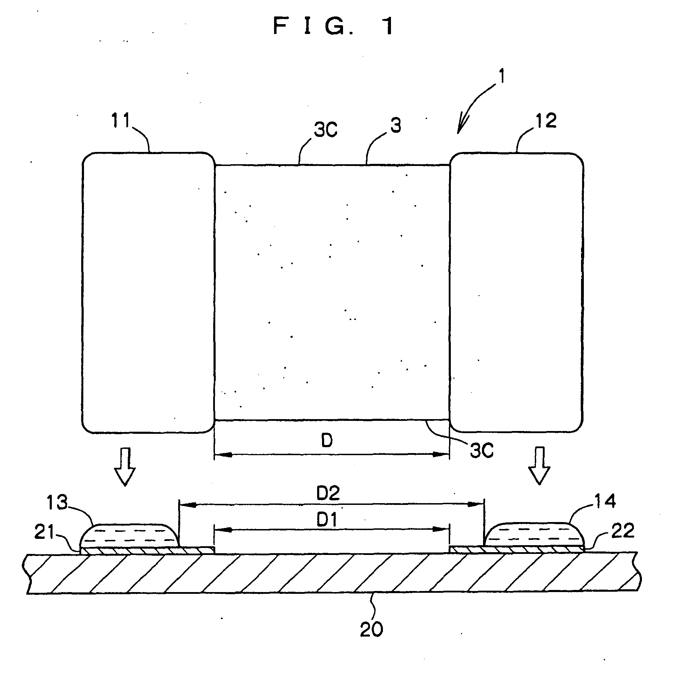

Hereinafter, embodiments of the electronic component mounting method and the electronic component mounting structure according to the present invention will be described based on the drawings. FIG. 1 to FIG. 4 show a multilayer ceramic capacitor (hereinafter, referred to as a multilayer capacitor) 1 being an electronic component according to a first embodiment of the present invention. The multilayer capacitor 1 includes, as a major portion thereof, a dielectric element 3 which is a sintered compact in a rectangular parallelepiped shape obtained by sintering a multilayer body formed of a stack of a plurality of ceramic green sheets.

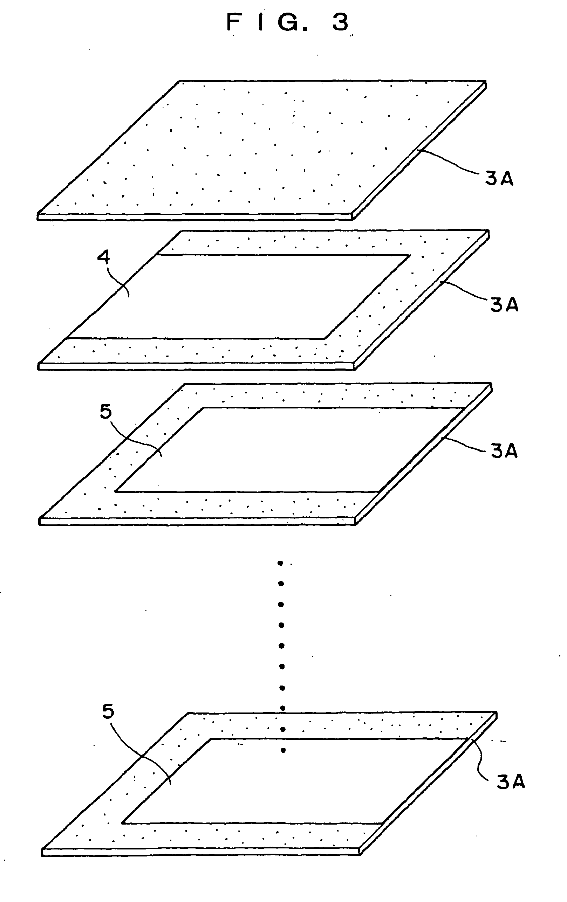

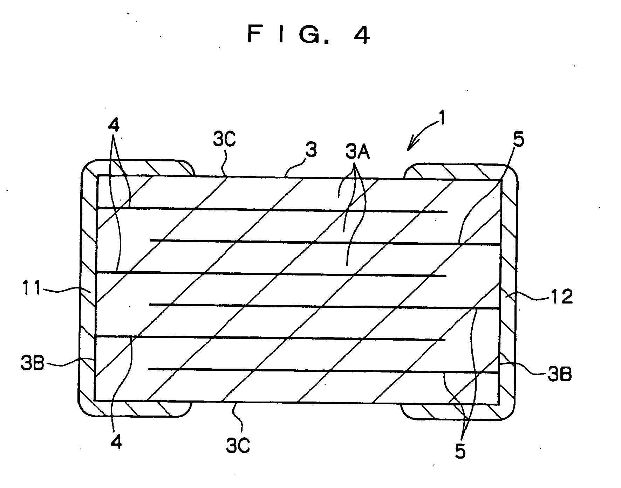

Therefore, the dielectric element 3 is formed of a stack of dielectric layers which are the sintered ceramic green sheets. Further, as shown in FIG. 3 and FIG. 4, the dielectric element 3 has the internal structure such that a planar internal conductor 4 is disposed at a predetermined height position in this dielectric element 3. An internal conductor 5 similarly in a planar shape is disposed under the internal conductor 4 across a ceramic layer 3A which is the dielectric layer in the dielectric element 3. Thereafter, a plurality of layers (for example, about 100 layers) of the internal conductors 4 and the internal conductors 5 each similarly formed across the ceramic layer 3A are repeatedly arranged.

Therefore, two kinds of the internal conductors, namely, the internal conductors 4 and the internal conductors 5, are arranged in the dielectric element 3 to face each other, being separated from each other by the ceramic layers 3A, as shown in FIG. 4. The centers of the internal conductors 4 and the internal conductors 5 are substantially aligned with the centers of the respective ceramic layers 3A. The length and width dimensions of the internal conductors 4 and the internal conductors 5 are smaller than the lengths of corresponding sides of the ceramic layers 3A, respectively.

Note that a conductor with the same width dimension as the width dimension of the internal conductor 4 protrudes from a left side portion of each of the internal conductors 4 toward a left end of the ceramic layer 3A as shown in FIG. 3. Further, a conductor with the same width dimension as the width dimension of the internal conductor 5 protrudes from the right side portion of each of the internal conductor 5 toward the right end of the ceramic layer 3A.

As shown in FIG. 4, a terminal electrode 11 connected to the left protruding portions of the internal conductors 4 is disposed on a left side face 3B that is an outer side of the dielectric element 3, and a terminal electrode 12 connected to the right protruding portions of the internal conductors 5 is disposed on a right side face 3B that is an outer side of the dielectric element 3.

As seen from the above description, in this embodiment, the multilayer capacitor 1 has the pair of terminal electrodes 11, 12, the pair of terminal electrodes 11, 12 being arranged on the two side faces 3B, respectively, out of four side faces of the dielectric element 3 in a rectangular parallelepiped shape of the multilayer capacitor 1. Note that when an interval dimension between the pair of terminal electrodes 11, 12 shown in FIG. 1 is defined as D, this interval dimension D is set to 500 µm or less.

On a circuit board 20 on which the multilayer capacitor 1 is mounted, a pair of lands 21, 22 connected to the pair of terminal electrodes 11, 12 respectively are provided to face the pair of terminal electrodes 11, 12. Note that a gap dimension between the pair of lands 21, 22 is defined as D1. Accordingly, the gap dimension D1 is set equal to the interval dimension D between the pair of terminal electrodes 11, 12 in this embodiment.

When the multilayer capacitor 1 is mounted on the circuit board 20, it is necessary to connect the terminal electrode 11 to the land 21 and connect the terminal electrode 12 to the land 22. At this time, they are connected to each other in such a manner that a conductive adhesive 13 containing resin is used to bond the terminal electrode 11 to the land 21, and a conductive adhesive 14 similarly containing resin is used to bond the terminal electrode 12 to the land 22.

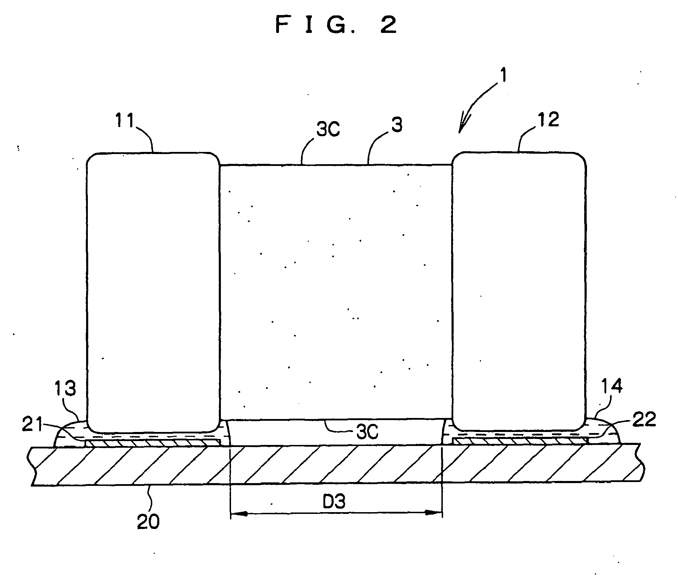

Specifically, as shown in FIG. 1, the pair of conductive adhesives 13, 14 are printed on the pair of lands 21, 22 respectively, with a gap dimension D2 between the pair of conductive adhesives 13, 14 being set larger than the gap dimension D1 between the pair of lands 21, 22 by 100 µm or more. Thereafter, as shown in FIG. 2, the multilayer capacitor 1 is mounted on the circuit board 20 while the pair of terminal electrodes 11, 12 are bonded to the pair of lands 21, 22 via the conductive adhesives 13, 14, respectively. Consequently, the structure in which the conductive adhesives 13, 14 connect therebetween is obtained.

Next, the operation of a mounting method and a mounting structure of the multilayer capacitor 1 according to this embodiment will be described.

The multilayer capacitor 1 according to this embodiment is structured such that the plural internal conductors 4 and the plural internal conductors 5 are arranged in the dielectric element 3 formed of a stack of the ceramic layers 3A, being separated from each other by the ceramic layers 3A. The pair of terminal electrodes 11, 12 are further provided on the outer sides of the dielectric element 3.

In this embodiment, the pair of conductive adhesives 13, 14 are printed on the pair of lands 21, 22 respectively, with the gap dimension D2 between the pair of conductive adhesives 13, 14 being wider than the gap dimension D1 between the pair of lands 21, 22 by 100 µm or more. Thereafter, the multilayer capacitor 1, which includes the pair of terminal electrodes 11, 12, with the interval dimension D therebetween being 500 µm or less, is placed on the circuit board 20, so that the multilayer capacitor 1 is mounted on the circuit board 20 while being bonded thereto via the conductive adhesives 13, 14. Therefore, the pair of terminal electrodes 11, 12 are bonded to the pair of lands 21, 22 via the conductive adhesives 13, 14 respectively, so that the multilayer capacitor 1 is mounted on the circuit board 20.

With this structure, the occurrence of the aforementioned problem of short or the like is prevented in this embodiment, as a result of widening the gap dimension D2 between the pair of conductive adhesives 13, 14 than the gap dimension D1 between the pair of lands 21, 22 by 100 µ m or more when the conductive adhesives 13, 14 are printed on the pair of lands 21, 22.

Specifically, an excessive amount of the conductive adhesives 13, 14 or an excessively high pressure for mounting the multilayer capacitor 1 on the circuit board 20 cause the conductive adhesives 13, 14 to be crushed and spread between the terminal electrodes 11, 12 of the multilayer capacitor 1 and the circuit board 20. Even in such a case, the conductive adhesives 13, 14 spread toward outer sides of the pair of lands 21, 22 as shown in FIG. 2 since the conductive adhesives 13, 14 are not printed on portions of the pair of lands 21, 22 on a side where the pair of lands 21, 22 face each other as shown in FIG. 1. Consequently, the occurrence of short or ion migration caused by the conductive adhesives 13, 14 is prevented in this embodiment.

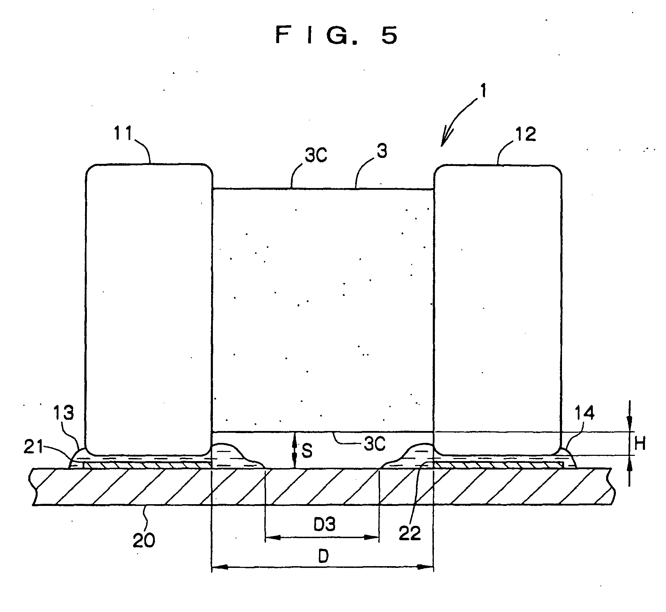

Next, an electronic component mounting method and an electronic component mounting structure according to a second embodiment of the present invention will be described based on FIG. 5. The same reference numerals and symbols are used to designate the same members as those described in the first embodiment, and repeated description thereof will be omitted. This embodiment is also structured, similarly to the first embodiment, such that a multilayer capacitor 1 includes a pair of terminal electrodes 11, 12, and an interval dimension D µ m between the pair of terminal electrodes 11, 12 is set to 500 µm or less.

In the first embodiment, the gap dimension D2 between the pair of conductive adhesives 13, 14 is made wider than the gap dimension D1 between the pair of lands 21, 22 by 100 µ m or more. On the other hand, in this embodiment, the pair of terminal electrodes 11, 12 are formed to satisfy the relation that H × D is 4000 or more, where H µm is a thickness dimension of portions of the terminal electrodes 11, 12 facing the lands 21, 22, and D µm is an interval dimension between the pair of terminal electrodes 11, 12.

When the multilayer capacitor 1 is mounted on a circuit board 20 via the conductive adhesives 13, 14, the conductive adhesives 13, 14 are first printed on the pair of lands 21, 22 respectively. After this printing, the multilayer capacitor 1 having the pair of terminal electrodes 11, 12 that are formed in the above-described manner is mounted on the circuit board 20 while being bonded thereto via the conductive adhesives 13, 14. Therefore, also in this embodiment, the pair of terminal electrodes 11, 12 are bonded to the pair lands 21, 22 via the conductive adhesives 13, 14 respectively, so that the multilayer capacitor 1 is mounted on the circuit board 20.

With the structure described above, this embodiment prevents the occurrence of the aforementioned problem of short or the like as a result of forming the pair of terminal electrodes 11, 12 such that H × D, which is a product of the thickness dimension H µm of the portions of the terminal electrodes 11, 12 facing the lands 21, 22 and the interval dimension D µ m between the pair of terminal electrodes 11, 12, is 4000 or more.

In other words, an interval dimension S between a portion sandwiched by the pair of terminal electrodes 11, 12 in the multilayer capacitor 1 and the circuit board 20 is widened, so that the conductive adhesives 13, 14 do not spread more than necessary even when the conductive adhesives 13, 14 are crushed between the terminal electrodes 11, 12 of the multilayer capacitor 1 and the circuit board 20. Consequently, this embodiment also prevents the occurrence of short or ion migration.

Next, the results of experiments on the correlation of the multilayer capacitor's characteristics that are required as a multilayer capacitor to the aforementioned dimensions D1, D2 are shown in Table 1, and the results will be discussed below based on Table 1.

Specifically, seven kinds of samples were prepared as examples 1 to 7. In the seven samples, the gap dimension D2 between the pair of conductive adhesives 13, 14 was made larger than the interval dimension D between the pair of terminal electrodes 11, 12 and the gap dimension D1 between the pair of lands 21, 22 by 100 µm or more and not more than 150 µm. Nine kinds of samples were also prepared as comparative examples 1 to 9. In these nine samples, the gap dimension D2 was not wider than the interval dimension D and the gap dimension D 1 by 100 µm or more.

Note that the abovementioned interval dimension D and gap dimension D1 were set equal to each other, and the interval dimension D and the gap dimension D1 were set to 500 µm or less in all the samples. Specifically, the interval dimension D and the gap dimension D 1 were set to four different kinds of values, namely, 500 µm, 400 *µ*m, 300 µm, and 200 µm, and the gap dimension D2 between the conductive adhesives 13, 14 after being printed was set to 600 µm to 200 µm. Further, the printed thickness of the conductive adhesives 13, 14 was 25 ±10 µ m.

Four items were defined as evaluation items in Table 1, namely, the gap dimension D3 between the conductive adhesives 13, 14 after mount (in Table 1, noted as conductive adhesive gap dimension D3 after mount), electric characteristic after mount, PCBT result, and moisture resistance cycle test result. The electric characteristic after mount among these evaluation items was the result of confirming the respective electric characteristics of Cp, tanδ, and IR after mount. Further, the PCBT result was obtained under a high-temperature, high humidity, and high pressure condition of 121°C, 95% RH, and 2 atmW.V./100 hr. In each of the items, OK represents that a predetermined standard was satisfied and NG represents that the predetermined standard was not satisfied.

**[Table 1]**

| No. | interval dimension D and gap dimension D1 (µm) | conductive adhesive gap dimension D2 (µm) | conductive adhesive gap dimension D3 after mount (µm) | electric characteristic after mount | PCBT result | moisture resistance cycle test result |
|---|---|---|---|---|---|---|
| example 1 | 500 | 600 | 480 | OK | OK | OK |
| comparative example 1 | | 550 | 250 | OK | OK | NG |
| comparative example 2 | | 500 | 155 | OK | NG | NG |
| comparative example 3 | | 450 | 95 | OK | NG | NG |
| example 2 | 400 | 550 | 400 | OK | OK | OK |
| example 3 | | 500 | 380 | OK | OK | OK |
| comparative example 4 | | 450 | 180 | OK | OK | NG |
| comparative example 5 | | 400 | 45 | OK | NG | NG |
| example 4 | 300 | 450 | 300 | OK | OK | OK |
| example 5 | | 400 | 270 | OK | OK | OK |
| comparative example 6 | | 350 | 145 | OK | OK | NG |
| comparative example 7 | | 300 | 0 | NG | - | - |
| example 6 | 200 | 350 | 200 | OK | OK | OK |
| example 7 | | 300 | 200 | OK | OK | OK |
| comparative example 8 | | 250 | 120 | OK | NG | NG |
| comparative example 9 | | 200 | 0 | NG | - | - |

As shown in Table 1, the gap dimension D3 between the conductive adhesives 13, 14 after mount in the examples 1 to 7 was substantially equal to the original gap dimension D2. On the other hand, the gap dimension D3 between the conductive adhesives 13, 14 after mount in the comparative examples 1 to 9 became significantly smaller than the original gap dimension D2. Accordingly, the comparative samples 7, 9 in which the gap dimension D3 became zero were evaluated as NG in the electric characteristic after mount.

The comparative examples 2, 3, 5, 8 in which the gap dimension D3 between the conductive adhesives 13, 14 after mount was 150 µ m or less were evaluated as NG in the PCBT result. In the moisture resistance cycle test result, the comparative examples 1 to 6 and 8 with a narrow gap dimension D3 were evaluated as NG. Note that no evaluation on the PCBT result and the moisture resistance cycle test result was made for the comparative examples 7, 9 that were evaluated as NG in the electric characteristic after mount.

Therefore, the examples 1 to 7 had no problem since they were all evaluated as OK as the results of the respective test items, but the comparative examples 1 to 9 were evaluated as NG in some test items. Therefore, from the results shown in Table 1, it was confirmed that the gap dimension D2 between the pair of conductive adhesives 13, 14 has to be larger than the gap dimension D1 between the pair of lands 21, 22 by 100 µm or more when they are printed.

Next, the results of experiments on the correlation of the multilayer capacitor's characteristics that are necessary as a multilayer capacitor to the aforementioned dimensions H, D are shown in Table 2, and the results will be discussed below based on Table 2.

Specifically, four kinds of samples were prepared as examples 8 to 11. In these four samples, H × D, which is the product of the thickness dimension H µm of the portions of the pair of terminal electrodes 11, 12 facing the pair of lands 21, 22 respectively and the interval dimension D µm between the pair of terminal electrodes 11, 12, was set to 4000 or more and not more than 5000. Eight samples in which H × D was set to less than 4000 were also prepared as comparative examples 10 to 17.

Note that the interval dimension D and the gap dimension D1 were set equal to each other. Further, the interval dimension D and the gap dimension D1 were set to 500 µm or less in all the samples. Specifically, the interval dimension D and the gap dimension D 1 were set to four different kinds of values, namely, 500 *µ*m, 400 µm, 300 µm, and 200 µm, and the thickness dimension H was set to 5 µm to 20 µm.

As in Table 1, four items were defined as evaluation items in Table 2, namely, the gap dimension D3 between the conductive adhesives 13, 14 after mount, electric characteristic after mount, PCBT result, and moisture resistance cycle test result.

**[Table 2]**

| No. | interval dimension D and gap dimension D1 (µm) | thickness dimension H (µm) | H × D | conductive adhesive gap dimension D3 after mount (µm) | electric characteristic after mount | PCBT result | moisture resistance cycle test result |
|---|---|---|---|---|---|---|---|
| comparative example 10 | 500 | 5 | 2500 | 20 | OK | NG | NG |
| comparative example 11 | | 7.5 | 3750 | 160 | OK | OK | NG |
| example 8 | | 10 | 5000 | 270 | OK | OK | OK |
| comparative example 12 | 400 | 5 | 2000 | 0 | NG | - | - |
| comparative example 13 | | 7.5 | 3000 | 45 | OK | NG | NG |
| example 9 | | 10 | 4000 | 200 | OK | OK | OK |
| comparative example 14 | 300 | 10 | 3000 | 35 | OK | NG | NG |
| comparative example 15 | | 12.5 | 3750 | 120 | OK | OK | NG |
| example 10 | | 15 | 4500 | 190 | OK | OK | OK |
| comparative example 16 | 200 | 15 | 3000 | 0 | NG | - | - |
| comparative example 17 | | 17.5 | 3500 | 55 | OK | OK | NG |
| example 11 | | 20 | 4000 | 185 | OK | OK | OK |

As shown in Table 2, in the examples 8 to 11, 180 µ m or more was ensured for the gap dimension D3 between the conductive adhesives 13, 14 after mount. On the other hand, the gap dimension D3 between the conductive adhesives 13, 14 after mount was 160 µ m or less in all the comparative examples 10 to 17. Accordingly, the comparative examples 12, 16 in which the gap dimension D3 between the conductive adhesives 13, 14 after mount was zero were evaluated as NG in the electric characteristic after mount.

Further, the comparative examples 10, 13, 14 in which the gap dimension D3 between the conductive adhesives 13, 14 after mount was 150 µ m or less were evaluated as NG in the PCBT result. Moreover, the comparative examples 10, 11, 13 to 15, 17 each having a narrow gap dimension D3 were evaluated as NG also in the moisture resistance cycle test result. Note that no evaluation on the PCBT result and moisture resistance cycle test result was made for the comparative examples 12, 16 evaluated as NG in the electric characteristic after mount.

Therefore, the examples 8 to 11 had no problem since they were all evaluated as OK as the results of the respective test items, but the comparative examples 10 to 17 were evaluated as NG in some test items. Therefore, from the results shown in Table 2, it was confirmed that H × D, which is the product of the thickness dimension H µm of the portions of the pair of terminal electrodes 11, 12 facing the pair of lands 21, 22 respectively and the interval dimension D µm between the pair of terminal electrodes 11, 12, has to be set to 4000 or more.

Incidentally, it is conceivable to adopt known conductive adhesives as the conductive adhesives used in the above-described embodiments. Further, viscosity of paste for terminal electrodes may be changed or the number of times of immersing the terminal electrodes in the paste may be increased in order to increase the thickness of the terminal electrodes. Moreover, the number of the internal conductors of the multilayer capacitor 1 is not limited to that in the multilayer capacitor 1 according to the above-described embodiments, but may be larger. Further, the order of the internal conductors in the layering direction may be arbitrarily changed.

According to the present invention, it is possible to obtain an electronic component mounting method and an electronic component mounting structure that prevent the occurrence of short or ion migration even when a conductive adhesive is crushed between an electronic component and a circuit board. The present invention is particularly suitable for use in mounting a multilayer ceramic capacitor on a circuit board.

## Claims

1. An electronic component mounting method for mounting an electronic component (1), which includes a pair of terminal electrodes (11, 12) with an interval dimension therebetween on a circuit board (20) by bonding the pair of terminal electrodes (11, 12) to a pair of lands (21, 22) of the circuit board (20) via conductive adhesives (13, 14) respectively,
***characterized in that:***
the pair of conductive adhesives (13, 14) are printed with a printed thickness dimension of 25 ± 10 µm on the pair of lands (21, 22) respectively with a gap dimension between the pair of conductive adhesives (13, 14) being larger than a gap dimension between the pair of lands (21, 22) of 100 to 150 µm, and
thereafter, the electro component (1) is mounted on the circuit board (20) while being bonded to the circuit board (20) via the conductive adhesives (13, 14) and the gap dimension between the pair of conductive adhesives (13, 14) is 200 µm or more after mount.

2. An electronic component mounting method for mounting an electronic component (1), which includes a pair of terminal electrodes (11, 12) with an interval dimension therebetween on a circuit board (20) by bonding the pair of terminal electrodes (11, 12) to a pair of lands (21, 22) of the circuit board (20) via conductive adhesives (13, 14) respectively,
***characterized in that:***
the pair of terminal electrodes (11, 12) are formed to satisfy a relation that H is 10 to 20 µm and H x D gives a value of a range of 4000 to 5000 where H µm is a thickness dimension of portions of the terminal electrodes (11, 12) facing the lands (21, 22) and D µm is an interval dimension between the pair of terminal electrodes (11, 12), and
after the conductive adhesives (13, 14) are next printed on the pair of lands (21, 22) respectively, the electro component (1) is mounted on the circuit board (20) while being bonded to the circuit board (20) via the conductive adhesives (13, 14), and the gap dimension between the pair of conductive adhesives (13, 14) is 180 µm or more after mount.

3. An electronic component mounting structure in which an electronic component (1), which includes a pair of terminal electrodes (11, 12) with an interval dimension therebetween is mounted on a circuit board (20) by bonding the pair of terminal electrodes (11, 12) to a pair of lands (21, 22) of the circuit board (20) via conductive adhesives (13, 14) respectively,
***characterized in that:***
the pair of terminal electrodes (11, 12) are formed to satisfy a relation that H is 10 to 20 µm and H x D gives a value of range of 4000 to 5000, where H µm is a thickness dimension of portions of the terminal electrodes (11, 12) facing the lands (21, 22) and D µm is an interval dimension between the pair of terminal electrodes (11, 12); and
the electro component (1) is mounted on the circuit board (20) while being bonded to the circuit board (20) via the conductive adhesives (13, 14) and the gap dimension between the pair of conductive adhesives (13, 14) is 180 µm or more after mount.

4. The electronic component mounting structure according to claim 3,
***characterized in that:***
the electronic component (1) is a multilayer ceramic capacitor housing two kinds of internal conductors (4, 5), the internal conductor of one kind being connected to one of the pair of terminal electrodes (11, 12), and the internal conductor of the other kind being connected to the other terminal electrode.

5. The electronic component mounting structure according to claim 3,
***characterized in that:***
a major portion of the electronic component (1) is formed of a stack of dielectric layers that are ceramic layers (3A) and formed in a rectangular parallelepiped shape.

6. The electronic component mounting structure according to claim 3,
***characterized in that:***
the conductive adhesives (13, 14) contain resin.

## Patentansprüche

1. Elektronisches Bauteilmontierungsverfahren zum Montieren eines elektronischen Bauteils (1), welches ein Paar terminale Elektroden (11, 12) mit einer dazwischen liegenden Abstandsdimension auf einer Platine (20) durch Binden des Paares der terminalen Elektroden (11, 12) jeweils auf ein Paar von Anschlussflächen (21, 22) auf der Platine (20) über leitende Klebemittel (13, 14) beinhaltet,
**dadurch gekennzeichnet, dass**
das Paar leitende Klebemittel (13, 14) das Anschlussflächenpaar (21, 22) mit einer gedruckten Dickendimension von 25 ± 10 µm mit einer Abstandsdimension zwischen dem Paar der leitenden Klebemittel (13, 14), die größer sind als die Abstandsdimension zwischen dem Paar der Anschlussflächen (21, 22) von 100 bis 150 µm, und wobei das elektronische Bauteil (1) auf der Platine (20) anschließend montiert wird, während es auf die Platine (20) über die leitenden Klebemittel (13, 14) gebunden wird, und wobei die Abstandsdimension zwischen dem Paar der leitenden Klebemittel (13, 14) 200 µm oder mehr nach dem Montieren ist.

2. Elektronisches Bauteilmontierungsverfahren zum Montieren eines elektronischen Bauteils (1), welches ein Paar terminale Elektroden (11, 12) mit einer dazwischen liegenden Abstandsdimension auf einer Platine (20) durch Binden des Paares der terminalen Elektroden (11, 12) jeweils auf ein Paar von Anschlussflächen (21, 22) auf der Platine (20) über leitende Klebemittel (13, 14) beinhaltet,
**dadurch gekennzeichnet, dass**
das Paar der terminalen Elektroden (11, 12) so ausgebildet ist, um einer Beziehung zu genügen, in der H 10 bis 20 µm ist und H x D einen Wert in einem Bereich von 4000 bis 5000 ergibt, worin H µm eine Dickendimension der Abschnitte der terminalen Elektronen (11, 12) ist, die den Anschlussflächen (21, 22) zugewandt ist, und D µm eine Abstandsdimension zwischen dem Paar der terminalen Elektronen (11, 12) ist, und
nachdem die leitenden Klebemittel (13, 14) als nächstes auf das Paar der Anschlussflächen (21, 22) jeweils gedruckt worden sind, das elektronische Bauteil (1) auf der Platine montiert wird, während es auf der Platine (20) über die leitenden Klebemittel (13, 14) gebunden ist und worin die Abstandsdimension zwischen dem Paar der leitenden Klebemittel (13, 14) 180 µm oder mehr nach dem Montieren ist.

3. Elektronische Bauteilmontierstruktur, in welcher ein elektronisches Bauteil (1), welches jeweils ein Paar terminale Elektroden (11, 12) mit einer Abstandsdimension dazwischen auf eine Platine (20) durch Binden des Paares der terminalen Elektroden (11, 12) jeweils auf ein Paar von Anschlussflächen (21, 22) auf die Platine (20) über leitende Klebemittel (13, 14) beinhaltet,
**dadurch gekennzeichnet, dass**
das Paar der terminalen Elektroden (11, 12) so ausgebildet ist, um einer Beziehung zu genügen, in der H 10 bis 20 µm ist und H x D einen Wert in einem Bereich von 4000 bis 5000 ergibt, worin H µm eine Dickendimension der Abschnitte der terminalen Elektronen (11, 12) ist, die den Anschlussflächen (21, 22) zugewandt ist, und D µm die Abstandsdimension zwischen dem Paar der terminalen Elektronen (11, 12) ist, und
das elektronische Bauteil (1) auf der Platine (20) montiert ist, während es auf der Platine (20) über die leitenden Klebemittel (13, 14) gebunden ist und worin die Abstandsdimension zwischen dem Paar der leitenden Klebemittel (13, 14) 180 µm oder mehr nach dem Montieren ist.

4. Elektronische Bauteilmontierstruktur nach Anspruch 3,
**dadurch gekennzeichnet, dass**
das elektronische Bauteil (1) ein vielschichtiges Keramikkondensatorgehäuse ist, das zwei Arten interner Innenkondensatoren (4, 5) aufnimmt, wobei der Innenkondensator der einen Art mit einem Paar der terminalen Elektroden (11, 12) verbunden ist und der Innenkondensator der anderen Art mit der anderen terminalen Elektrode verbunden ist.

5. Elektronische Bauteilmontierstruktur nach Anspruch 3,
**dadurch gekennzeichnet, dass**
ein größerer Teil des elektronischen Bauteils (1) als ein Stapel dielektrischer Schichten, die keramische Schichten (3A) sind, und in Gestalt eines rechtwinkligen Parallelepipeds ausgebildet ist.

6. Elektronische Bauteilmontierstruktur nach Anspruch 3,
**dadurch gekennzeichnet, dass**
die leitenden Klebemittel (13, 14) Harz enthalten.

## Revendications

1. Procédé de montage de composant électronique afin d'assurer le montage d'un composant électronique (1), qui comporte une paire d'électrodes de borne (11, 12) avec une certaine dimension d'intervalle entre elles sur une carte de circuit (20) en collant la paire d'électrodes de borne (11, 12) sur une paire d'îlots (21, 22) de la carte de circuit (20) respectivement par l'intermédiaire d'adhésifs conducteurs (13, 14),
**caractérisé en ce que :**
la paire d'adhésifs conducteurs (13, 14) est imprimée avec une dimension d'impression en épaisseur de 25 ± 10 µm respectivement sur la paire d'îlots (21, 22), la dimension d'intervalle entre la paire d'adhésifs conducteurs (13, 14) étant supérieure à la dimension d'intervalle entre la paire d'îlots (21, 22) de 100 à 150 µm, et
ensuite, le composant électronique (1) est monté sur la carte de circuit (20) tout en étant collé sur la carte de circuit (20) par l'intermédiaire des adhésifs conducteurs (13, 14) et la dimension d'intervalle entre la paire d'adhésifs conducteurs (13, 14) est supérieure ou égale à 200 µm après montage.

2. Procédé de montage de composant électronique afin d'assurer le montage d'un composant électronique (1), qui comporte une paire d'électrodes de borne (11, 12) avec une certaine dimension d'intervalle entre elles sur une carte de circuit (20) en collant la paire d'électrodes de borne (11, 12) sur une paire d'îlots (21, 22) de la carte de circuit (20) respectivement par l'intermédiaire d'adhésifs conducteurs (13, 14),
**caractérisé en ce que :**
la paire d'électrodes de borne (11, 12) est formée de manière à satisfaire une relation telle que H est compris entre 10 et 20 µm et H x D donne une valeur dans une plage de 4000 à 5000 dans laquelle H en µm représente une dimension en épaisseur de parties des électrodes de borne (11, 12) faisant face aux îlots (21, 22) et D en µm représente une dimension d'intervalle entre les électrodes de la paire d'électrodes de borne (11, 12), et
après, les adhésifs conducteurs (13, 14) sont ensuite imprimés respectivement sur la paire d'îlots (21, 22), le composant électronique (1) est monté sur la carte de circuit (20) tout en étant collé sur la carte de circuit (20) par l'intermédiaire des adhésifs conducteurs (13, 14), et la dimension d'intervalle entre la paire d'adhésifs conducteurs (13, 14) est supérieure ou égale à 180 µm après montage.

3. Structure de montage de composant électronique dans laquelle un composant électronique (1), qui comporte une paire d'électrodes de borne (11, 12) avec une certaine dimension d'intervalle entre elles est montée sur une carte de circuit (20) en collant la paire d'électrodes de borne (11, 12) sur une paire d'îlots (21, 22) de la carte de circuit (20) respectivement par l'intermédiaire d'adhésifs conducteurs (13, 14),
**caractérisée en ce que** :
la paire d'électrodes de borne (11, 12) est formée de manière à satisfaire une relation telle que H est compris entre 10 et 20 µm et H x D donne une valeur dans une plage de 4000 à 5000 dans laquelle H en µm représente une dimension en épaisseur de parties des électrodes de borne (11, 12) faisant face aux îlots (21, 22) et D en µm représente une dimension d'intervalle entre les électrodes de la paire d'électrodes de borne (11, 12), et
le composant électronique (1) est monté sur la carte de circuit (20) tout en étant collé sur la carte de circuit (20) par l'intermédiaire des adhésifs conducteurs (13, 14) et la dimension d'intervalle entre la paire d'adhésifs conducteurs (13, 14) est supérieure ou égale à 180 µm après montage.

4. Structure de montage de composant électronique selon la revendication 3, **caractérisée en ce que** :
le composant électronique (1) est un condensateur céramique multicouche contenant deux types de conducteurs internes (4, 5), le conducteur interne du premier type étant raccordé à l'une de la paire d'électrodes de borne (11, 12), et le conducteur interne de l'autre type étant raccordé à l'autre électrode de borne.

5. Structure de montage de composant électronique selon la revendication 3,
**caractérisée en ce que** :
une grande partie du composant électronique (1) est constituée par un empilement de couches diélectriques qui sont des couches de céramique (3A), et est réalisée en forme de parallélépipède rectangle.

6. Structure de montage de composant électronique selon la revendication 3, **caractérisée en ce que** :
les adhésifs conducteurs (13, 14) contiennent de la résine.
